# EUROPEAN PATENT APPLICATION

(11) **EP 4 806 298 A1**
(43) Date of publication of application: **16.09.2026**
(21) Application number: 26163713.6
(22) Date of filing: 10.03.2026
(51) Int. Cl.: A47B 47/04, H02B 1/044, H02B 1/26, H02B 1/30, H05K 7/18

(54) **MODULAR PLINTH SYSTEM**

(30) Priority: 12.03.2025 IN 202511022294
(71) Applicant: Vertiv Corporation, Westerville, OH 43082 (US)
(72) Inventor: PIMPALE, Mahesh, Ahmednagar (IN); MUSALE, Rahul, 411015 Datta Nagar (IN); SHAH, Akshay, 411048 Khondwa Khurd Pune (IN); JETHVA, Kishan Jaysukh-bhai, 411057 Pune (IN)
(74) Representative: Beal, James Michael

(57) **Abstract**

The present disclosure provides a modular plinth system **200,** comprising a plurality of plinth modules **201a, 201b, 201c, 201d,** wherein each of the plurality of the Rectangular channel plinth module **201a, 201b, 201c, 201d** are aligned adjacently at a predetermined distance from each other to form an outer frame structure of variable size, and wherein outer side wall of each of the plurality of the plinth module **201a, 201b, 201c, 201d** include at least one plinth sliding slot **203.** The system **200** further comprises a plurality of support brackets **202a, 202b, 202c, 202d,** wherein each of the support brackets **202a, 202b, 202c, 202d** includes a bracket sliding slot **204,** and a bracket **205** with one or more fastening mechanism **206,** wherein each of the support bracket **202a, 202b, 202c, 202d** is placed over the outer side walls of two adjacently placed plinth modules **201a, 201b, 201c, 201d** to align the at least one plinth sliding slot **203** with the bracket sliding slot **204,** and fasten the at least one plinth sliding slot **203** with the bracket sliding slot **204** using the bracket **205** with the one or more fastening mechanism **206.**

## Description

### TECHNICAL FIELD

The present disclosure generally relates to plinths for Outside Plant (OSP) system. More particularly, the present disclosure relates to a modular plinth configured to accommodate varying cabinet footprint sizes, thereby reducing inventory complexity, simplifying installation, and enhancing structural flexibility.

### BACKGROUND

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches, which in and of themselves may also correspond to implementations of the claimed technology.

Plinths serve as a stable base for cabinets and provide space for cable entry. The plinths may be open-frame or enclosed with sheet metal sidewalls. Existing outdoor telecommunications and utility cabinets, commonly deployed in Outside Plant (OSP) environments, rely on plinths for structural support, load distribution, and environmental protection. However, conventional plinths are manufactured in fixed sizes (e.g., 32", 34", 36", 38"), requiring users to maintain multiple inventory stock-keeping units, leading to increased storage costs, logistical challenges, and reduced flexibility in adapting to new or modified cabinet designs.

Accordingly, there is a need for a modular plinth system that accommodates multiple cabinet footprint sizes, minimizing inventory requirements, enabling rapid adjustments, and simplifying assembly.

### SUMMARY OF THE INVENTION

This summary is provided to introduce aspects related to a spacer for front access circuit breakers in power systems and the aspects are further described below in the detailed description. This summary is not intended to identify essential features of the present subject matter nor is it intended for use in determining or limiting the scope of the present subject matter.

In an embodiment of the present invention, a modular plinth system comprises a plurality of plinth modules, wherein each plinth module is aligned adjacent to another plinth module at a predetermined distance so as to collectively form an outer frame structure of variable size. An outer side wall of each plinth module includes at least one plinth sliding slot. The modular plinth system further comprises a plurality of support brackets, wherein each support bracket includes a bracket sliding slot and a bracket provided with one or more fastening mechanisms. Each support bracket is positioned over the outer side walls of two adjacently placed plinth modules such that the plinth sliding slot is aligned with the bracket sliding slot, and the aligned slots are fastened using the bracket and the one or more fastening mechanisms, thereby securing the plinth modules to define the outer frame structure.

In one embodiment of the present invention, the modular plinth system includes a plurality of plinth modules, wherein the plinth modules are configured as rectangular channel plinth modules.

In one embodiment of the present invention, the plurality of plinth modules are arranged to form an outer frame structure having a shape selected from at least one of a square shape or a rectangular shape, with the outer frame structure being configurable to different sizes.

In one embodiment of the present invention, each support bracket is configured to be placed over outer side walls of two adjacently arranged plinth modules.

In one embodiment of the present invention, each support bracket includes a bracket sliding slot provided to align with a plinth sliding slot provided on a corresponding plinth module.

In one embodiment of the present invention, the modular plinth system includes a fastening mechanism, wherein the fastening mechanism comprises a bolt-type fastening member.

In one embodiment of the present invention, each plinth module includes a plinth sliding slot provided on an outer side wall of the plinth module.

In one embodiment of the present invention, each support bracket includes a bracket body configured to receive the fastening mechanism.

In one embodiment of the present invention, the fastening mechanism is removably coupled to the support bracket.

In yet another embodiment of the present invention, the plurality of plinth modules together define the outer frame structure of the modular plinth system.

Other aspects and advantages of the invention will become apparent from the following description, taken in conjunction with the accompanying drawings, illustrating by way of example the principles of the invention.

### BRIEF DESCRIPTION OF THE DRAWINGS

The accompanying figures of the drawing, which are included to provide a further understanding of general aspects of the system/method, are incorporated in and constitute a part of this specification. These illustrative aspects of the system/method, and together with the detailed description, explain the principles of the system. No attempt is made to show structural details in more detail than is necessary for a fundamental understanding of the system and various ways in which it is practiced. The following figures of the drawing include:
**Fig. 1** illustrates perspective views of existing plinths system.
**Fig. 2** illustrates a perspective view of a modular plinth system, in accordance with an embodiment of the present invention.
**Fig. 3** illustrates a perspective view of the modular plinth system configured to support varying sizes of Outside Plant (OSP) cabinet, in accordance with an embodiment of the present invention.

In the appended figures, similar components and/or features may have the same numerical reference label. Further, various components of the same type may be distinguished by following the reference label with a letter. If only the first numerical reference label is used in the specification, the description is applicable to any one of the similar components and/or features having the same first numerical reference label irrespective of the suffix.

### DETAILED DESCRIPTION OF THE INVENTION

Illustrative embodiments are described with reference to the accompanying drawings. Wherever convenient, the same reference numbers are used throughout the drawings to refer to the same or like parts. While examples and features of disclosed principles are described herein, modifications, adaptations, and other implementations are possible without departing from the spirit and scope of the disclosed embodiments. It is intended that the following detailed description be considered as exemplary only, with the true scope and spirit being indicated by the following claims.

Outside Plant (OSP) cabinets are essential components in telecommunications and utility networks, providing protection and housing for critical equipment. OSP cabinets are generally placed on a plinth which provides base support for footprint of the OSP cabinets. The footprint on the plinth refers to the base area of the cabinet, which must be precisely aligned with the plinth to ensure stability, load distribution, and proper anchoring and for cable Management. A key limitation of having different plinth sizes for varying OSP cabinet footprints is the challenge of standardization, Increase Inventory for different plinths leading to compatibility issues and structural instability.

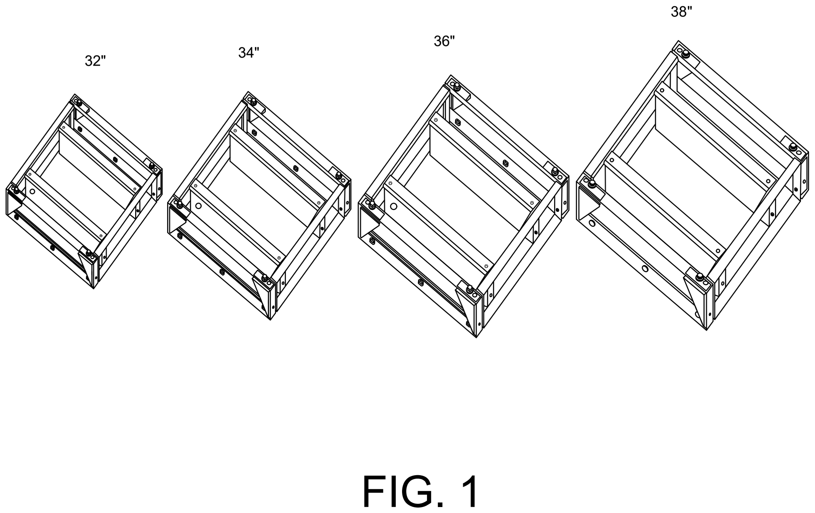

**Figure 1** illustrates perspective views of existing plinth. Currently, multiple plinth sizes (e.g., 32", 34", 36", and 38") may be required to accommodate different cabinet dimensions. This results in separate inventory management, leading to increased storage costs, assembly complexity, and reduced adaptability. Assembly times vary due to the need for different installation procedures. There is a need for a mechanism for standardizing the plinth size to accommodate multiple footprints can mitigate the above issues, ensuring easier deployment OSP cabinets of varying sizes.

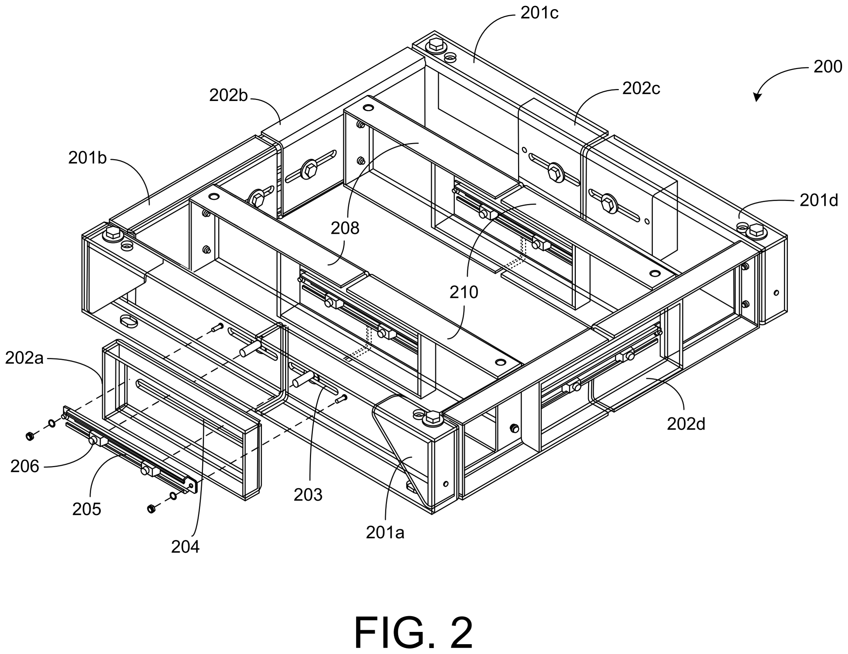

To address these challenges, the present invention provides a modular plinth system that supports multiple cabinet sizes using a single adjustable design. The modular plinth system further reduces inventory requirements, simplifies assembly, and enhances installation efficiency. A more detailed explanation of the modular plinth system is provided with reference to Fig. 2 and forthcoming explanation.

**Figure 2** illustrates a perspective view of a modular plinth system **200,** in accordance with an embodiment of the present invention. The modular plinth system **200** may comprise a plurality plinth modules **201a, 201b, 201c, 201d.** In an embodiment, the plinth modules **201a, 201b, 201c, 201d** are rectangular channel plinth modules. The plurality of rectangular channel plinth modules **201a, 201b, 201c, 201d** can be aligned adjacently at a predetermined distance from each other to form an outer frame structure of variable size which can accommodate OSP cabinets of different sizes and also the rectangular channel is for strength purpose In an embodiment, the outer frame structure may be selected from a group consisting of rectangular or square shapes. Further, the material for the plinth modules can be selected from the group of materials including metal, composite materials, such as steel ensuring durability and load-bearing capacity.

Generally, the footprints of the OSP cabinets are either in square or rectangular shape, for which rectangular channel plinth modules are preferred which can be aligned together to provide varying sizes of frame structure to accommodate varying footprints of the OSP cabinets. In an embodiment, each plinth module **201a, 201b, 201c, 201d** have at least one plinth sliding slot **203,** which facilitates secure attachment to at least one support brackets **202a, 202b, 202c, 202d.** The support brackets **202a, 202b, 202c, 202d** facilitate proper alignment as per of the plinth modules **201a, 201b, 201c, 201d** and structural stability of the modular plinth system and which can be used for adjustment of the plinth as per different footprint sizes of the cabinet.

In an exemplary embodiment, the rectangular channel plinth modules have perpendicular extending walls, wherein each wall includes a plinth sliding slot **203.** For example, when a square frame structure of a particular size needs to be prepared, four rectangular channel plinth modules are arranged at a predetermined distance from each other thereby forming a desired size of square frame. By placing the rectangular channel plinth modules in the square arrangement, the plinth sliding slot **203** of each of the adjacent wall of plinth modules are aligned on a common plane. In order to securely align the adjacently placed plinth modules, the one or more support brackets **202a, 202b, 202c, 202d** are provided.

In an embodiment, each support bracket **202a, 202b, 202c, 202d** is mounted over the outer sidewall of adjacently placed two rectangular channel plinth modules **201a, 201b, 201c, 201d,** in all 4 directions, ensuring a firm connection of the frame structure. In an embodiment, each of the support bracket **202a, 202b, 202c, 202d** further includes a bracket sliding slot **204,** a bracket **205** and a fastening mechanism **206,** allowing for precise positioning and fastening to the rectangular channel plinth modules **201a, 201b, 201c, 201d.**

In an exemplary embodiment, when the support bracket **202a** is placed over the adjacently placed rectangular channel plinth modules **201a, 201b,** the plinth sliding slots **203** of the plinth modules **201a, 201b** and the bracket sliding slot **204** are aligned on a common plane for fastening. Upon placing the support bracket **202a** over the walls of the plinth modules **201a, 201b,** the support bracket **202a** is fastened with the walls of the plinth modules **201a, 201b** using the bracket **205** and the fastening mechanism **206** in a tight arrangement.

Similarly, the above arrangement of the support brackets **202a, 202b, 202c, 202d** with the plinth modules **201a, 201b, 201c, 201d** in all four directions to rigidly form a support structure of varying sizes for OSP cabinets.

The interaction between the plinth sliding slot **203** and the bracket sliding slot **204** ensures a secure and adjustable assembly, accommodating variations in frame size. In one embodiment, the fastening mechanism **206** is a T-bolt assembly configured to securely engage both the bracket sliding slot **204** and the plinth sliding slot 203, thereby locking the rectangular channel plinth modules **201a** and **201b** in a desired position while allowing for easy adjustments.

In a further embodiment, the modular plinth system **200** may further comprise supporting blocks **208, 210** mounted within the outer frame structure, configured to provide the additional structural support to the modular plinth system **200.** In one embodiment, the supporting blocks **208, 210** are made of steel to provide structural strength and stability. In an exemplary embodiment, the supporting blocks **208, 210** may also comprise sliding slots, which can be aligned with additional support brackets as explained above, for adjustment according to the size of the outer frame structure.

For example, in an outdoor telecommunications setup, the modular plinth system **200** is used to support OSP (Outside Plant) cabinets. The plurality of rectangular channel plinth modules **201a, 201b, 201c, 201d** are aligned adjacently at a predetermined distance to form an outer frame structure. To accommodate different cabinet sizes, the system allows for adjustable spacing between the plinth modules.

During installation, the fastening mechanism **206,** such as a nut assembly, is initially loosely engaged, allowing relative movement between the bracket sliding slot **204** and the plinth sliding slot **203.** As a result, the rectangular channel plinth modules **201a** and **201b** may be adjusted by sliding along the slots to achieve the desired spacing. When an extended configuration is required - such as increasing the frame size from 32 inches to 38 inches - the second plinth module **201b** is moved outward accordingly.

Once the desired position is reached, the nut assembly of the fastening mechanism **206** is tightened, securing the bracket **205** and locking the plinth modules in place. This ensures structural stability and a firm foundation for supporting OSP cabinets while maintaining flexibility for future adjustments.

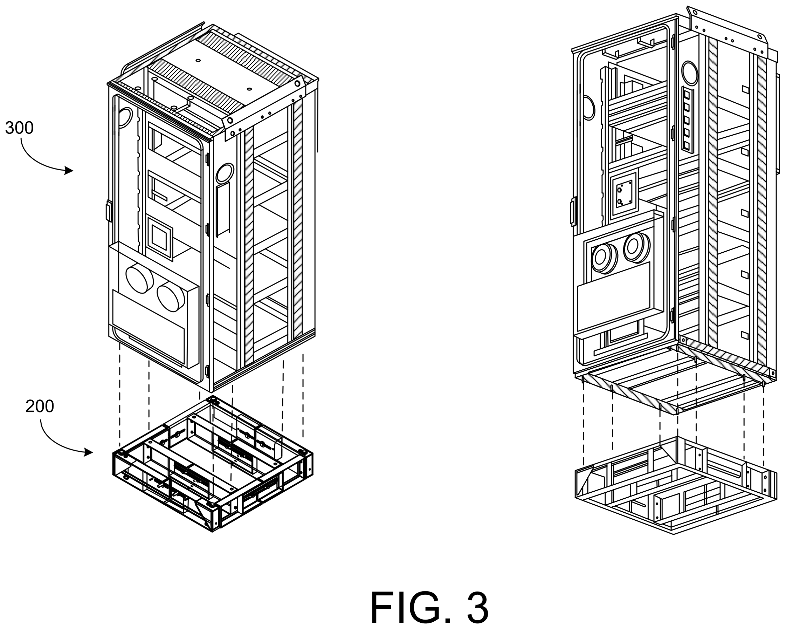

**Figure** 3 illustrates a perspective view of the modular plinth system **200** configured to support an Outside Plant (OSP) cabinet **300,** in accordance with an embodiment of the present invention. The modular plinth system **200** is designed to provide structural reinforcement, load distribution, cable entry and stability to the OSP cabinet **300.** The modular plinth system **200** facilitates secure attachment of the OSP cabinet **300** through precisely positioned fasteners and interlocking connectors. The modular plinth system **200** further allows for easy installation, alignment, and maintenance, ensuring enhanced durability and adaptability for various deployment environments.

The systems, devices discussed herein are examples. Various embodiments may omit, substitute, or add various procedures or components as appropriate. For instance, in alternative embodiments, the methods may be performed in an order different from that described, and/or various stages may be added, omitted, and/or combined. Also, features described with respect to certain embodiments may be combined in various other embodiments. Different aspects and elements of the embodiments may be combined in a similar manner. Also, technology evolves and, thus, many of the elements are examples and do not limit the scope of the disclosure or claims. Additionally, the techniques discussed herein may provide differing results with different types of context awareness classifiers.

Unless defined otherwise, all technical and scientific terms used herein have the same meaning as commonly or conventionally understood. As used herein, the articles "a" and "an" refer to one or to more than one (i.e., to at least one) of the grammatical object of the article. By way of example, "an element" means one element or more than one element. "About" and/or "approximately" as used herein when referring to a measurable value such as an amount, a temporal duration, and the like, encompasses variations of +20% or +10%, +5%, or +0.1% from the specified value, as such variations are appropriate to in the context of the systems, devices, circuits, methods, and other implementations described herein. "Substantially" as used herein when referring to a measurable value such as an amount, a temporal duration, a physical attribute (such as frequency), and the like, also encompasses variations of ±20% or ±10%, ±5%, or ±0.1% from the specified value, as such variations are appropriate to in the context of the systems, devices, circuits, methods, and other implementations described herein.

As used herein, including in the claims, "and" as used in a list of items prefaced by "at least one of" or "one or more of" indicates that any combination of the listed items may be used. For example, a list of "at least one of A, B, and C" includes any of the combinations A or B or C or AB or AC or BC and/or ABC (i.e., A and B and C). Furthermore, to the extent more than one occurrence or use of the items A, B, or C is possible, multiple uses of A, B, and/or C may form part of the contemplated combinations. For example, a list of "at least one of A, B, and C" may also include AA, AAB, AAA, BB, etc.

While illustrative and presently preferred embodiments of the disclosed systems, methods, and/or machine-readable media have been described in detail herein, it is to be understood that the inventive concepts may be otherwise variously embodied and employed, and that the appended claims are intended to be construed to include such variations, except as limited by the prior art. While the principles of the disclosure have been described above in connection with specific apparatuses and methods, it is to be clearly understood that this description is made only by way of example and not as limitation on the scope of the disclosure.

The disclosure comprises the following items:
1. A modular plinth system **200,** comprising:
   a plurality of plinth modules **201a, 201b, 201c, 201d,**
   wherein each of the plurality of the plinth module **201a, 201b, 201c, 201d** are aligned adjacently at a predetermined distance from each other to form an outer frame structure of variable size, and
   wherein outer side wall of each of the plurality of the plinth module **201a, 201b, 201c, 201d** include at least one plinth sliding slot **203;** and

   a plurality of support brackets **202a, 202b, 202c, 202d,**
      wherein each of the support brackets **202a, 202b, 202c, 202d** includes a bracket sliding slot **204,** and a bracket **205** with one or more fastening mechanism **206,**
   wherein
   each of the support bracket **202a, 202b, 202c, 202d** is placed over the outer side walls of two adjacently placed plinth modules **201a, 201b, 201c, 201d** to align the at least one plinth sliding slot **203** with the bracket sliding slot **204,** and fasten the at least one plinth sliding slot **203** with the bracket sliding slot **204** using the bracket **205** with the one or more fastening mechanism **206.**
2. The modular plinth system **200** of item 1, wherein the plinth modules **201a, 201b, 201c, 201d** are rectangular channel plinth modules.
3. The modular plinth system **200** of item 1 or item 2, wherein the outer frame structure has a shape selected from at least one of square shape or rectangular shape of varying sizes.
4. The modular plinth system **200** of any preceding item, wherein each support bracket **202a, 202b, 202c, 202d** is configured to be placed over outer side walls of two adjacently arranged plinth modules.
5. The modular plinth system **200** of any preceding item, wherein the bracket sliding slot **204** is provided on the support bracket to align with the plinth sliding slot provided on the plinth module.
6. The modular plinth system **200** of any preceding item, wherein the fastening mechanism **206** comprises a bolt-type fastening member.
7. The modular plinth system **200** of any preceding item, wherein each plinth sliding slot **203** is provided on the outer side wall of the corresponding plinth module.
8. The modular plinth system **200** of any preceding item, wherein each support bracket **202a, 202b, 202c, 202d** includes a bracket body configured to receive the fastening mechanism.
9. The modular plinth system **200** of any preceding item, wherein the fastening mechanism **206** is removably coupled to the support bracket.
10. The modular plinth system **200** of any preceding item, wherein the plurality of plinth modules **201a, 201b, 201c, 201d** together define the outer frame structure.

## Claims

1. A modular plinth system (200), comprising:
a plurality of plinth modules (201a, 201b, 201c, 201d),
wherein each of the plurality of plinth modules (201a, 201b, 201c, 201d) are aligned adjacently at a predetermined distance from each other to form an outer frame structure of variable size, and
wherein an outer side wall of each of the plurality of the plinth modules (201a, 201b, 201c, 201d) includes at least one plinth sliding slot (203) and
a plurality of support brackets (202a, 202b, 202c, 202d),
wherein each of the support brackets (202a, 202b, 202c, 202d) includes a bracket sliding slot (204), and a bracket (205) with one or more fastening mechanisms (206),
wherein
each of the support brackets (202a, 202b, 202c, 202d) is placed over the outer side walls of two adjacently placed plinth modules (201a, 201b, 201c, 201d) to align the at least one plinth sliding slot (203) with the bracket sliding slot (204), and the at least one plinth sliding slot (203) is fastened with the bracket sliding slot (204) using the bracket (205) with the one or more fastening mechanism (206).

2. The modular plinth system (200) as claimed in claim 1, wherein the plinth modules (201a, 201b, 201c, 201d) are rectangular channel plinth modules.

3. The modular plinth system (200) as claimed in claim 1 or claim 2, wherein the outer frame structure has a shape selected from at least one of square shape or rectangular shape of varying sizes.

4. The modular plinth system (200) as claimed in any preceding claim, wherein each support bracket (202a, 202b, 202c, 202d) is configured to be placed over outer side walls of two adjacently arranged plinth modules.

5. The modular plinth system (200) as claimed in any preceding claim, wherein the bracket sliding slot (204) is provided on the support bracket to align with the plinth sliding slot (203) provided on the plinth module.

6. The modular plinth system (200) as claimed in any preceding claim, wherein the fastening mechanism (206) comprises a bolt-type fastening member.

7. The modular plinth system (200) as claimed in any preceding claim, wherein each plinth sliding slot (203) is provided on the outer side wall of the corresponding plinth module.

8. The modular plinth system (200) as claimed in any preceding claim, wherein each support bracket (202a, 202b, 202c, 202d) includes a bracket body configured to receive the fastening mechanism.

9. The modular plinth system (200) as claimed in any preceding claim, wherein the fastening mechanism (206) is removably coupled to the support bracket.

10. The modular plinth system (200) as claimed in any preceding claim, wherein the plurality of plinth modules (201a, 201b, 201c, 201d) together define the outer frame structure.
